# EUROPEAN PATENT APPLICATION

(11) **EP 4 507 260 A1**
(43) Date of publication of application: **12.02.2025**
(21) Application number: 23190208.1
(22) Date of filing: 08.08.2023
(51) Int. Cl.: H04L 41/0896, G06N 3/08, G06N 20/00, H04L 41/14, H04Q 11/00, H04L 41/16, H04L 41/142

(54) **APPARATUSES AND METHODS FOR SELECTING CANDIDATES END POINTS IN A FIXED COMMUNICATION NETWORK**

(71) Applicant: Nokia Solutions and Networks Oy, 02610 Espoo (FI)
(72) Inventor: DROOGHAAG, Benoît, 1421 Ophain-Bois-Seigneur-Isaac (BE); BOSTOEN, Tom, 2000 Antwerp (BE)
(74) Representative: Loyer & Abello

(57) **Abstract**

A computer-implemented method for selecting candidates end points,
the method comprising:
- providing a first training dataset identifying training candidate end points to be allocated a bandwidth increment for a short time period,
- providing a first training success list identifying successful training candidate end points to be allocated a bandwidth increment for a long time period, wherein the successful training candidate end points are a subset of the first training candidate end points;
- performing supervised training of a first success prediction model for predicting the first training success list from the first training dataset
- determining a first predicted list by implementing the first success prediction model on a first reservoir dataset identifying first potential candidate end points belonging to the fixed communications network wherein the first predicted list identifies candidates end points as a subset of the first potential candidate end points,
- selecting a first candidate list identifying first candidate end points to be allocated a bandwidth increment, wherein the first candidate end points belong to the fixed communications network,
wherein the first candidate list includes part or all of the first predicted list.

## Description

### Field of the invention

The disclosure relates to apparatuses and methods for selecting candidates end points in a fixed communication network.

### Background

As network operators develop new and better technologies, they have to adapt the current running fixed communication network with the latest technologies. This adaptation to the latest technologies is called migration from an existing technology to a newer technology.

To optimize the migration of the fixed communication network and prioritize the area of a network where the needs are the higher, an operator wants to know where the migration should be done first. To know this, it has to identify the end points of the network where a higher bandwidth is or would be necessary.

One way to achieve this is to test the current end points of the network with a higher bandwidth.

However, since many fixed access networks like, for example, Passive Optical Network and Cable networs are shared medium, this can only be done to a few end points at a time to limit the overbooking factor and maintain the speed test success probability in an acceptable range. Operators are currently looking for a solution to identify in each network branch the end points who are the most likely to use a higher bandwidth. One solution is to offer them a short time trial period so they can test if they need and/or will need a higher bandwidth in the future.

As the number of end points able to support higher bandwidth of the short time trial period in each network branch at the same time is limited, it is critical to have a recommendation engine to identify the end points who are likely to need the higher servicers after the short time trial period with a maximum of reliability (highest hit rate).

However, for now, there is no objective method to identify the end points with higher needs other than predict them thanks to educated guesses such as simply monitoring their current telemetry history and recommending the end points associated to the subscribers having the highest data consumption but even those simple method have not been integrated and automated at BSS/OSS level nor in the access network controller.

Thus, there is a need for apparatuses and methods for selecting candidates end points.

### Summary

Apparatuses and methods for selecting candidates end points in a fixed communication network are disclosed.

In some embodiments, the disclosure provides a method for selecting candidates end points comprising:
- providing a first training dataset identifying training candidate end points to be allocated a bandwidth increment for a short time period, wherein the training candidate end points belong to a fixed communications network,
   the training dataset further comprising for each training candidate end point at least:
   a bandwidth allocation of the training candidate end point,
   a traffic consumption history of the training candidate end point,
- providing a first training success list identifying successful training candidate end points to be allocated a bandwidth increment for a long time period, wherein the successful training candidate end points are a subset of the first training candidate end points;
- performing supervised training of a first success prediction model for predicting the first training success list from the first training dataset
- determining a first predicted list by implementing the first success prediction model on a first reservoir dataset identifying first potential candidate end points belonging to the fixed communications network wherein the first predicted list identifies candidates end points as a subset of the first potential candidate end points,
   the first reservoir dataset comprising for each first potential candidate end point at least:
   a bandwidth allocation of the first potential candidate end point,
   a traffic consumption history of the first potential candidate end point, and
- selecting a first candidate list identifying first candidate end points to be allocated a bandwidth increment, wherein the first candidate end points belong to the fixed communications network,
wherein the first candidate list includes part or all of the first predicted list.

Thanks to these features, the method enables to select the end points of the fixed communication network with the highest probability of need or that require a bandwidth increment for a long time period.

This long time period is longer than the short time period. This long period can be comprised for example between one month to one or several years. The short time period can be comprised for example between one week to one month.

The method may also comprise one or more of the following features.

In an embodiment, the method further comprises:
- performing supervised training of another first success prediction model for predicting the first training success list from the first training dataset, the another first success prediction model being different from the first success prediction model.
- determining another first predicted list by implementing the another first success prediction model on the first reservoir dataset identifying first potential candidate end points belonging to the fixed communications network,

wherein the another first predicted list identifies candidates end points as a subset of the first potential candidate end points,
wherein the first candidate list includes part or all of the first predicted list and part of the another first predicted list.

Thanks to these features, two different prediction models are trained and can be compared. Any number of prediction models can be trained based on the same training dataset and success list. A prediction model trained with the first training dataset and the first success list is a prediction model of first generation.

Training various different prediction models can be useful to best cover or explore the fixed communication network. In addition, one model can be more explainable than the other. This more explainable model can be used to gain insights on the reasons why an end point has a higher probability to need a bandwidth increment for a long time period.

In an embodiment, the method further comprises:
- providing a second training dataset including the first candidate list and comprising for each second candidate end point, a bandwidth allocation of the second candidate end point, a traffic consumption history of the second candidate end point, and a value of the bandwidth increment for the short time period;
- providing a second success list identifying successful first candidate end points to be allocated a bandwidth increment for a long time period, wherein the successful second candidate end points are a subset of the second candidate end points;
- performing supervised training of a second success prediction model for predicting the second success list from the second training dataset,
- determining a second predicted list by implementing the second success prediction model on a second reservoir dataset identifying second potential candidate end points belonging to the fixed communications network wherein the second predicted list identifies candidates end points as a subset of the second potential candidate end points,
the second reservoir dataset comprising for each second potential candidate end point, a bandwidth allocation of the second potential candidate end point, a traffic consumption history of second potential candidate end point,
- selecting a second candidate list identifying second candidate end points to be allocated a bandwidth increment, wherein the second candidate end points belong to the fixed communications network,
wherein the second candidate list includes part or all of the second predicted list.

Thanks to these features, a candidate list more accurate than the first candidate list is selected thanks to a second supervised training.

In an embodiment, the method further comprises:
- performing supervised training of another second success prediction model for predicting the second training success list from the second training dataset, the another second success prediction model being different from the second success prediction model,
- determining another second predicted list by implementing the another second success prediction model on the second reservoir dataset identifying second potential candidate end points belonging to the fixed communications network,
wherein the second candidate list includes part of the second predicted list and part of the another second predicted list.

Thanks to these features, in a similar way with the various prediction model of first generation, training various different prediction models of second generation can be useful to best cover or explore the fixed communication network. In addition, one model can be more explainable than the other. This more explainable model can be used to gain insights on the reasons why an end point has a higher probability to need a bandwidth increment for a long time period.

In an embodiment, performing supervised training of a second success prediction model comprises performing supervised re-training of the first success prediction model for predicting the second success list from the second training dataset, wherein the second success prediction model is the re-trained first success prediction model.

Thanks to these features, the same prediction model is retrained and is more accurate. In other words, it is possible to improve from one generation to another the same prediction model.

In an embodiment, the first candidate list further identifies first candidate end points (O1) outside the first predicted list and/or outside the another first predicted list.

Thanks to these features, the risk to see the performance of this model degrading over time is reduced. Indeed, these features allow continuously exploring the entire end points base of the network, to detect new trends as soon as they appear in the network.

In an embodiment, selecting a first candidate list further comprises:
- selecting a first candidate end point outside the first predicted list as a function of at least a position of the first candidate end point in the fixed communications network, a bandwidth allocation of the first candidate end point, and a traffic consumption history of the first candidate end point; and/or
- randomly selecting a first candidate end point outside the first predicted list.

Thanks to these features, the exploration of the end points base of the network is set empirically and randomly. It is then possible to compare the accuracy of the prediction model with the end points selected thanks to methods different from implementing a prediction model.

In an embodiment, the method further comprises determining a success rate of the first predicted list as a function of the second success list and determining a success rate of the first candidate end points outside the first predicted list as a function of the second success list.

Thanks to these features, it is possible to evaluate and monitor the performance of the different methods of determining or selecting the end points.

In an embodiment, the method further comprises:
- in response to determining that the success rate of the first predicted list is higher than the success rate of the first candidate end points outside the first predicted list, the second candidate list is selected so that a proportion of the second predicted list within the second candidate list is higher than a proportion of the first predicted list within the first candidate list,
- providing a third training dataset including the second candidate list and comprising for each third candidate end point at least a position of the second candidate end point in the fixed communications network, a bandwidth allocation of the second candidate end point, a traffic consumption history of the second candidate end point, providing a third success list identifying successful third candidate end points to be allocated a bandwidth increment for a long time period, wherein the successful third candidate end points are a subset of the third candidate end points;
- performing supervised training of a third success prediction model for predicting the third success list from the third training dataset,
- determining a third predicted list by implementing the third success prediction model on a third reservoir dataset identifying third potential candidate end points belonging to the fixed communications network, wherein the third predicted list identifies candidates end points as a subset of the third potential candidate end points,
   the third reservoir dataset comprising for each third potential candidate end point at least, a bandwidth allocation of the third potential candidate end point, a traffic consumption history of third potential candidate end point,.
- selecting a third candidate list identifying third candidate end points to be allocated a bandwidth increment, wherein the third candidate end points belong to the fixed communications network,
wherein the third candidate list includes part or all of the third predicted list.

Thanks to these features, a third prediction model has been trained with the results of the first and second prediction models. Therefore, it is expected to be more accurate than the prediction model(s) of first generation and the prediction model(s) of second generation.

In an embodiment, the method further comprises:
- determining a success rate of the first predicted list as a function of the first success list and determining a success rate of the another first candidate end points of the another first predicted list as a function of the first success list.
- in response to determining that the success rate of the first predicted list is higher than the success rate of the another first candidate end points of the another first predicted list, the second candidate list is selected so that a proportion of the second predicted list within the second candidate list is higher than a proportion of the another second predicted list within the second candidate list.

Thanks to these features, a prediction model more accurate according to its success rate is responsible for a larger part of the next candidate list while a smaller part comes from a different prediction model to continue exploring the end points base.

In an embodiment, performing supervised training of a third success prediction model comprises:
- performing supervised re-re-training of the first success prediction model for predicting the third success list from the third training dataset, wherein the third success prediction model is the re-re-trained first success prediction model, or
- performing supervised re-training of the second success prediction model for predicting the third success list from the third training dataset, wherein the third success prediction model is the re-trained second success prediction model.

Thanks to these features, it is possible to improve from one generation to another the same prediction model.

In an embodiment, the first success prediction model, the second success prediction and/or the third success prediction model is one of the following:
- a logistic regression based model,
- a naïve bayes based model,
- a decision tree based model,
- a random forest based model,
- a support vector machine model,
- a K-nearest neighbor model,
- a neural network based model.

Thanks to these features, either a simple model is used (logistic regression, naive bayes, decision tree, ...) and in this case the importance of every input parameter can be recovered from the trained model parameters. Or a more complex supervised learning model is chosen (random forest, neural network) preventing the direct interpretation of the model parameters. In this latter case, many techniques are available to still determine the contribution to each input parameter to the model decision. These techniques include for example Permutation Feature Importance, Partial Dependene Plots, Individual Conditional Expectations, LIME and SHAP.

In an embodiment, the method according to the disclosure is implemented by an network access manager of the fixed communication network.

In an embodiment, the fixed communication network is an optical distribution network (ODN), for example a Gigabit-capable Passive Optical Network (GPON).

In some embodiments, the disclosure provides an apparatus comprising means for:
- providing a first training dataset identifying training candidate end points to be allocated a bandwidth increment for a short time period, wherein the training candidate end points belong to a fixed communications network,
   the training dataset further comprising for each training candidate end point at least:
   a bandwidth allocation of the training candidate end point,
   a traffic consumption history of the training candidate end point,
- providing a first training success list identifying successful training candidate end points to be allocated a bandwidth increment for a long time period, wherein the successful training candidate end points are a subset of the first training candidate end points;
- performing supervised training of a first success prediction model for predicting the first training success list from the first training dataset
- determining a first predicted list by implementing the first success prediction model on a first reservoir dataset identifying first potential candidate end points belonging to the fixed communications network wherein the first predicted list identifies candidates end points as a subset of the first potential candidate end points,
   the first reservoir dataset comprising for each first potential candidate end point at least:
   a bandwidth allocation of the first potential candidate end point,
   a traffic consumption history of the first potential candidate end point, and
- selecting a first candidate list identifying first candidate end points to be allocated a bandwidth increment, wherein the first candidate end points belong to the fixed communications network,
wherein the first candidate list includes part or all of the first predicted list.

In some example embodiments, the means in the apparatus further comprises:
At least one processor; and
At least one memory including a computer program code, the at least one memory and computer program code configured to, with the at least one processor, cause the operations of the apparatus.

The at least one memory and the computer program code may be configured to, with the at least one processor, cause the apparatus to:

performing supervised training of another first success prediction model for predicting the first training success list from the first training dataset, the another first success prediction model being different from the first success prediction model.

determining another first predicted list by implementing the another first success prediction model on the first reservoir dataset identifying first potential candidate end points belonging to the fixed communications network,
wherein the another first predicted list identifies candidates end points as a subset of the first potential candidate end points,
wherein the first candidate list includes part of the first predicted list and part of the another first predicted list.

The at least one memory and the computer program code may be configured to, with the at least one processor, cause the apparatus to:
- providing a second training dataset including the first candidate list and comprising for each second candidate end point, a bandwidth allocation of the second candidate end point, a traffic consumption history of the second candidate end point, providing a second success list identifying successful first candidate end points to be allocated a bandwidth increment for a long time period, wherein the successful second candidate end points are a subset of the second candidate end points;
- performing supervised training of a second success prediction model for predicting the second success list from the second training dataset,
- determining a second predicted list by implementing the second success prediction model on a second reservoir dataset identifying second potential candidate end points belonging to the fixed communications network wherein the second predicted list identifies candidates end points as a subset of the second potential candidate end points,
   the second reservoir dataset comprising for each second potential candidate end point, a bandwidth allocation of the second potential candidate end point, a traffic consumption history of second potential candidate end point,
- selecting a second candidate list identifying second candidate end points to be allocated a bandwidth increment, wherein the second candidate end points belong to the fixed communications network,
wherein the second candidate list includes part or all of the second predicted list.

The at least one memory and the computer program code may be configured to, with the at least one processor, cause the apparatus to:
- performing supervised training of another second success prediction model for predicting the second training success list from the second training dataset, the another second success prediction model being different from the second success prediction model,
- determining another second predicted list by implementing the another second success prediction model on the second reservoir dataset identifying second potential candidate end points belonging to the fixed communications network,
wherein the second candidate list includes part of the second predicted list and part of the another second predicted list.

The at least one memory and the computer program code may be configured to, with the at least one processor, cause the apparatus to:
- selecting a first candidate end point outside the first predicted list as a function of at least a position of the first candidate end point in the fixed communications network, a bandwidth allocation of the first candidate end point, and a traffic consumption history of the first candidate end point; and/or
- randomly selecting a first candidate end point outside the first predicted list.

The at least one memory and the computer program code may be configured to, with the at least one processor, cause the apparatus to:

performing supervised re-training of the first success prediction model for predicting the second success list from the second training dataset, wherein the second success prediction model is the re-trained first success prediction model.

The at least one memory and the computer program code may be configured to, with the at least one processor, cause the apparatus to:

determining a success rate of the first predicted list as a function of the second success list and determining a success rate of the first candidate end points outside the first predicted list as a function of the second success list.

The at least one memory and the computer program code may be configured to, with the at least one processor, cause the apparatus to:
- in response to determining that the success rate of the first predicted list is higher than the success rate of the first candidate end points outside the first predicted list, the second candidate list is selected so that a proportion of the second predicted list within the second candidate list is higher than a proportion of the first predicted list within the first candidate list,
- providing a third training dataset including the second candidate list and comprising for each third candidate end point at least a position of the second candidate end point in the fixed communications network, a bandwidth allocation of the second candidate end point, a traffic consumption history of the second candidate end point, providing a third success list identifying successful third candidate end points to be allocated a bandwidth increment for a long time period, wherein the successful third candidate end points are a subset of the third candidate end points;

- performing supervised training of a third success prediction model for predicting the third success list from the third training dataset,
- determining a third predicted list by implementing the third success prediction model on a third reservoir dataset identifying third potential candidate end points belonging to the fixed communications network, wherein the third predicted list identifies candidates end points as a subset of the third potential candidate end points,
   the third reservoir dataset comprising for each third potential candidate end point at least, a bandwidth allocation of the third potential candidate end point, a traffic consumption history of third potential candidate end point,.
- selecting a third candidate list identifying third candidate end points to be allocated a bandwidth increment, wherein the third candidate end points belong to the fixed communications network,
wherein the third candidate list includes part or all of the third predicted list.

The at least one memory and the computer program code may be configured to, with the at least one processor, cause the apparatus to:
- determining a success rate of the first predicted list as a function of the first success list and determining a success rate of the another first candidate end points of the another first predicted list as a function of the first success list.
- in response to determining that the success rate of the first predicted list is higher than the success rate of the another first candidate end points of the another first predicted list, the second candidate list is selected so that a proportion of the second predicted list within the second candidate list is higher than a proportion of the another second predicted list within the second candidate list.

The at least one memory and the computer program code may be configured to, with the at least one processor, cause the apparatus to:
- performing supervised re-re-training of the first success prediction model for predicting the third success list from the third training dataset, wherein the third success prediction model is the re-re-trained first success prediction model, or
- performing supervised re-training of the second success prediction model for predicting the third success list from the third training dataset, wherein the third success prediction model is the re-trained second success prediction model.

The at least one memory and the computer program code may be configured to, with the at least one processor, cause the apparatus to:

In some example embodiments, the disclosure also provides an apparatus comprising:
- A first providing circuitry configured to provide a first training dataset identifying training candidate end points to be allocated a bandwidth increment for a short time period, wherein the training candidate end points belong to a fixed communications network,
   the training dataset further comprising for each training candidate end point at least:
   a bandwidth allocation of the training candidate end point,
   a traffic consumption history of the training candidate end point,
- A second providing circuitry configured to provide a first training success list identifying successful training candidate end points to be allocated a bandwidth increment for a long time period, wherein the successful training candidate end points are a subset of the first training candidate end points;
- A first performing circuitry configured to perform supervised training of a first success prediction model for predicting the first training success list from the first training dataset
- A first determining circuitry configured to determine a first predicted list by implementing the first success prediction model on a first reservoir dataset identifying first potential candidate end points belonging to the fixed communications network wherein the first predicted list identifies candidates end points as a subset of the first potential candidate end points,
   the first reservoir dataset comprising for each first potential candidate end point at least:
   a bandwidth allocation of the first potential candidate end point,
   a traffic consumption history of the first potential candidate end point, and
- A first selecting circuitry configured to select a first candidate list identifying first candidate end points to be allocated a bandwidth increment, wherein the first candidate end points belong to the fixed communications network,
wherein the first candidate list includes part or all of the first predicted list.

In an embodiment, the apparatus further comprises:
- A second performing circuitry configured to perform supervised training of another first success prediction model for predicting the first training success list from the first training dataset, the another first success prediction model being different from the first success prediction model.
- A second determining circuitry configured to determine another first predicted list by implementing the another first success prediction model on the first reservoir dataset identifying first potential candidate end points belonging to the fixed communications network,

wherein the another first predicted list identifies candidates end points as a subset of the first potential candidate end points,
wherein the first candidate list includes part of the first predicted list and part of the another first predicted list.

According to an embodiment, the apparatus further comprises:
- a third providing circuitry configured to provide a second training dataset including the first candidate list and comprising for each second candidate end point, a bandwidth allocation of the second candidate end point, a traffic consumption history of the second candidate end point, and a value of the bandwidth increment for the short time period;
- a fourth providing circuitry configured to provide a second success list identifying successful first candidate end points to be allocated a bandwidth increment for a long time period, wherein the successful second candidate end points are a subset of the second candidate end points;
- a third performing circuitry configured to perform supervised training of a second success prediction model for predicting the second success list from the second training dataset,
- a third determining circuitry configured to determine a second predicted list by implementing the second success prediction model on a second reservoir dataset identifying second potential candidate end points belonging to the fixed communications network wherein the second predicted list identifies candidates end points as a subset of the second potential candidate end points,
   the second reservoir dataset comprising for each second potential candidate end point, a bandwidth allocation of the second potential candidate end point, a traffic consumption history of second potential candidate end point,
- a second selecting circuitry configured to select a second candidate list identifying second candidate end points to be allocated a bandwidth increment, wherein the second candidate end points belong to the fixed communications network,
wherein the second candidate list includes part or all of the second predicted list.

According to an embodiment, the apparatus further comprises:
- A fourth performing circuitry configured to perform supervised training of another second success prediction model for predicting the second training success list from the second training dataset, the another second success prediction model being different from the second success prediction model,
- A fourth determining circuitry configured to determine another second predicted list by implementing the another second success prediction model on the second reservoir dataset identifying second potential candidate end points belonging to the fixed communications network,
wherein the second candidate list includes part of the second predicted list and part of the another second predicted list.

According to an embodiment, the apparatus further comprises:
- a third selecting circuitry configured to select a first candidate end point outside the first predicted list as a function of at least a position of the first candidate end point in the fixed communications network, a bandwidth allocation of the first candidate end point, and a traffic consumption history of the first candidate end point; and/or
- a fourth selecting circuitry configured to randomly selecting a first candidate end point outside the first predicted list.

According to an embodiment, the apparatus further comprises:
- A fifth determining circuitry configured to determine a success rate of the first predicted list as a function of the second success list and determining a success rate of the first candidate end points outside the first predicted list as a function of the second success list.

According to an embodiment, the apparatus further comprises:
- A fifth selecting circuitry configured to, in response to determining that the success rate of the first predicted list is higher than the success rate of the first candidate end points outside the first predicted list, select the second candidate list so that a proportion of the second predicted list within the second candidate list is higher than a proportion of the first predicted list within the first candidate list,
- A fifth providing circuitry configured to provide a third training dataset including the second candidate list and comprising for each third candidate end point at least a position of the second candidate end point in the fixed communications network, a bandwidth allocation of the second candidate end point, a traffic consumption history of the second candidate end point, A sixth providing circuitry configured to provide a third success list identifying successful third candidate end points to be allocated a bandwidth increment for a long time period, wherein the successful third candidate end points are a subset of the third candidate end points;
- A fifth performing configured to perform supervised training of a third success prediction model for predicting the third success list from the third training dataset,
- A sixth determining circuitry configured to determine a third predicted list by implementing the third success prediction model on a third reservoir dataset identifying third potential candidate end points belonging to the fixed communications network, wherein the third predicted list identifies candidates end points as a subset of the third potential candidate end points,
   the third reservoir dataset comprising for each third potential candidate end point at least, a bandwidth allocation of the third potential candidate end point, a traffic consumption history of third potential candidate end point,.
- A fifth selecting circuitry configured to select a third candidate list identifying third candidate end points to be allocated a bandwidth increment, wherein the third candidate end points belong to the fixed communications network,
wherein the third candidate list includes part or all of the third predicted list.

According to an embodiment, the apparatus further comprises:
- A seventh determining circuitry configured to determine a success rate of the first predicted list as a function of the first success list and determining a success rate of the another first candidate end points of the another first predicted list as a function of the first success list.
- A sixth selecting circuitry configured to, in response to determining that the success rate of the first predicted list is higher than the success rate of the another first candidate end points of the another first predicted list, select the second candidate list so that a proportion of the second predicted list within the second candidate list is higher than a proportion of the another second predicted list within the second candidate list.

According to an embodiment, the apparatus further comprises:
- A sixth performing circuitry configured to perform supervised training of a second success prediction model comprises performing supervised re-training of the first success prediction model for predicting the second success list from the second training dataset, wherein the second success prediction model is the re-trained first success prediction model.

According to an embodiment, the apparatus further comprises:
- A seventh performing circuitry configured to perform supervised re-re-training of the first success prediction model for predicting the third success list from the third training dataset, wherein the third success prediction model is the re-re-trained first success prediction model, or
- An eight performing circuitry configured to perform supervised re-training of the second success prediction model for predicting the third success list from the third training dataset, wherein the third success prediction model is the re-trained second success prediction model

### Brief description of the drawings

For a more complete understanding of example embodiments of the present invention, reference is now made to the following descriptions taken in connection with the accompanying drawings in which:
FIG. 1 shows a functional diagram of a method for selecting candidates end points when one first prediction model is trained and then implemented.
FIG. 2 shows a functional diagram of a method for selecting candidates end points where two first prediction models are trained and then implemented.
FIG. 3 shows a functional diagram of a method for selecting candidates end points where a second prediction model is trained and then implemented.
FIG. 4 shows a functional diagram of a method for selecting candidates end points where two second prediction models are trained and then implemented.
FIG. 5 shows a functional diagram of a method for selecting candidates end points where a candidate list comprised end points outside a predicted list obtained with a prediction model.
FIG. 6 and 7 show a functional diagram of a method for selecting candidates end points where two first prediction models are trained and then implemented and two second prediction models are trained and then implemented.
FIG. 8 is a block diagram depicting the apparatus 1200 operating in accordance with an example embodiment described above.

### Detailed description of embodiments

Example embodiments of the present application are described herein in detail and shown by way of example in the drawings. It should be understood that, although specific embodiments are discussed herein there is no intent to limit the scope of the invention to such embodiments. To the contrary, it should be understood that the embodiments discussed herein are for illustrative purposes, and that modified and alternative embodiments may be implemented without departing from the scope of the invention as defined in the claims. The sequence of method steps is not limited to the specific embodiments, the method steps may be performed in other possible sequences. Similarly, specific structural and functional details disclosed herein are merely representative for purposes of describing the embodiments. The invention described herein, however, may be embodied in many alternate forms and should not be construed as limited to only the embodiments set forth herein.

### Summary of the invention

A proposition is to leverage the fact that multiple successive campaigns consisting of short time trial periods are needed to cover all the end points of a fixed communication network.

The fixed communication network can be a land mobile network, a land computer network, a FTTH network or even a Gigabit-capable Passive Optical Network.

The following described methods and all the described embodiments can be implemented by the network access manager of the fixed communication network.

A proposition is to use a combination of white-boxed/educated-guesses algorithms and supervised learning models to recommend a list of end points eligible for a short time trial period. After each short time trial period, the supervised learning models are retrained and a reinforcement learning algorithm is used to allocate more or less weight to the different educated-guesses algorithms and supervised learning models.

### Method

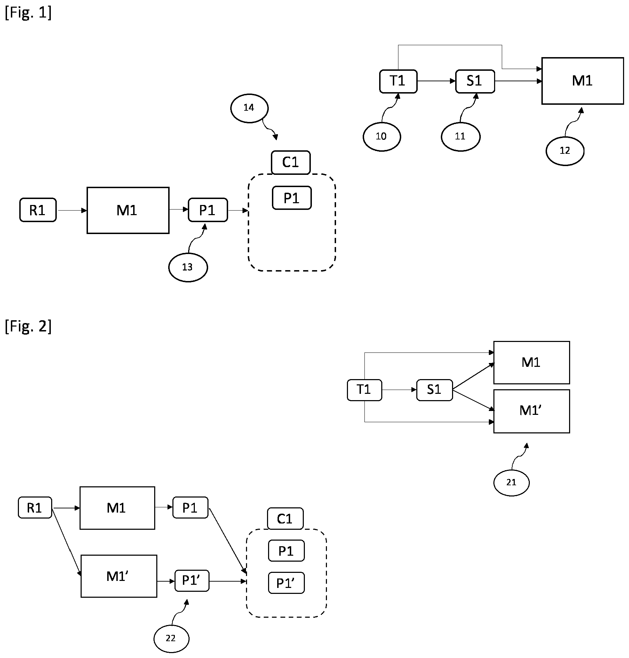

As illustrated at figure 1, for the first short time trial, there is no supervised learning prediction model available yet.

Thus, in order to build a first prediction model M1, a first training dataset T1 is provided at step 10 of figure 1. For example, this first training dataset can be based on the educated-guess algorithm(s).

A simple example of such an algorithm could consist in recommending for the trial the n subscribers having the highest data consumption in every network branches, n being a network constraint parameter representing the maximum number of upgradable subscribers per branch. To that end, the data consumption of every subscriber can be measured using the network telemetry.

However, as this algorithm is only an educated guess, it is wise to benchmark it against a plain simple random sampling algorithm i.e. selecting n subscribers in each network branch at random.

As it is expected that the educated guess algorithm will perform better than the random sampling, it is possible allocate more "weight" to the educated-guess algorithm. For example, the allocation is initially set empirically, for example, 80% of the end points will use the educated-guess algorithm and 20% of the end points will use the random sampling.

However, any proportion between the weight of the various methods used to determine the first list of end points T1 can be used. For example, it is possible to determine the first list of end points T1 with 100% of educated-guess end points or 100% of random end points.

This training dataset T1 further comprising for each training candidate end point at least:
- a bandwidth allocation of the training candidate end point,
- a traffic consumption history of the training candidate end point,

Then, the end points of the list T1 are allocated a bandwidth increment for a short time period.

At the end of the short time period illustrated at step 11, it is possible to provide a first training success list S1 identifying successful training candidate end points to be allocated a bandwidth increment for a long time period.

By definition, the successful training candidate end points of the first success list S1 are a subset of the first training candidate end points comprised in the first list T1.

Then, thanks to the first training dataset T1 and the first success list S1, a supervised training of a first success prediction model M1 for predicting the first training success list from the first training dataset is performed at step 12.

It is possible to combine the first training dataset T1 and the first success list S1 with any other information that the operator can collect about the end points, either from the network telemetry (traffic consumption over time, number and types of ethernet and wifi devices connected to the home gateway) or from any other sources, within the limits of the applicable data privacy regulation (address, professional activity, family composition, social media activity, ...). For example, at least one the following inputs can be user to perform the supervised training of the first success prediction model M1:
- a position of the training candidate terminal in the fixed communications network,
- a bandwidth allocation of the training candidate terminal,
- a traffic consumption history of the training candidate terminal,
- a value of the bandwidth increment for the short time period;
- a topology constraint of the fixed communications network, and/or
- traffic consumption history of the fixed communications network.

The first prediction model M1 can be one of the following:
- a logistic regression based model,
- a naive bayes based model,
- a decision tree based model,
- a random forest based model,
- a support vector machine model,
- a K-nearest neighbor model
- a neural network based model.

An advantage allowed by the invention is that supervised learning models can always be interpreted (or explained) such that one can recover from the prediction model what are the main reasons for predicting one value or the other.

The choice of model is not critical for this application. Either a simple model is used (logistic regression, naive bayes, decision tree, ...) and in this case the importance of every input parameter can be recovered from the trained model parameters. Or a more complex supervised learning model is chosen (random forest, neural network) preventing the direct interpretation of the model parameters, but many techniques are available to still determine the contribution to each input parameter to the model decision. These model-agnostic methods include for example Permutation Feature Importance, Partial Dependence Plots, Individual Conditional Expectation, LIME (Local Interpretable Model-Agnostic Explanations) and SHAP (Shapely Additive Explanations).

This model M1 can then be used for a next short time trial as an alternative or complement to the educated guess algorithm(s).

So, at step 13, the model M1 is implemented on the first reservoir dataset R1 comprising for each first potential candidate end point at least:
- a bandwidth allocation of the first potential candidate end point,
- a traffic consumption history of the first potential candidate end point.

Thus, a first predicted list P1 is determined. This first predicted list P1 identifying first potential candidate end points belonging to the fixed communications network. The first predicted list P1 identifies candidates end points as a subset of the first potential candidate end points comprised in the first reservoir dataset R1.

Then, at step 14, it is possible to define a first candidate list C1 identifying first candidate end points to be allocated a bandwidth increment, wherein the first candidate end points belong to the fixed communications network.

Thus, the first candidate list C1 includes part or all of the first predicted list P1.

This first candidate list C1 can be used by the network operator to identify the end points of the network where a higher bandwidth is or would be necessary.

### Improvements and/or alternative embodiments

In an alternative embodiment illustrated at figure 2, two prediction models are training based on the first training dataset T1 and the first success list S1.

The first prediction model M1 is trained as explained above. In addition, at step 21, one another first prediction model M1' is trained for predicting the first training success list 51 from the first training dataset T1.

The another first prediction model M1' is a first model as it is trained with the same first training dataset T1 and the first success list 51 as the first prediction model M1. However, the another first prediction model M1' is different from the first prediction model M1. For example, it can be a different type of model among the following:
- a logistic regression based model,
- a naïve bayes based model,
- a decision tree based model,
- a random forest based model,
- a support vector machine model,
- a K-nearest neighbor model,
- a neural network based model.

For example, the model M1 is a logistic regression based model and the model M1' is naïve bayes based model.

It is also possible that the two prediction models M1 and M1' are of the same type but with a different architecture.

The two prediction models M1 and M1' are prediction models of first generation since they are trained with the first training dataset T1 and the first success list S1.

Any number of different prediction models of first generation can be trained.

Then at step 22, in addition to step 13 relative to the implementation of the first prediction model M1, the another first prediction model M1' is implemented on the first reservoir dataset R1 to determine another first predicted list P1'. This another first predicted list P1' identifies candidates end points as a subset of the first potential candidate end points.

Then, the first candidate list C1 is selected with part of both the first predicted list P1 and the another first predicted list P1' as illustrated at figure 2.

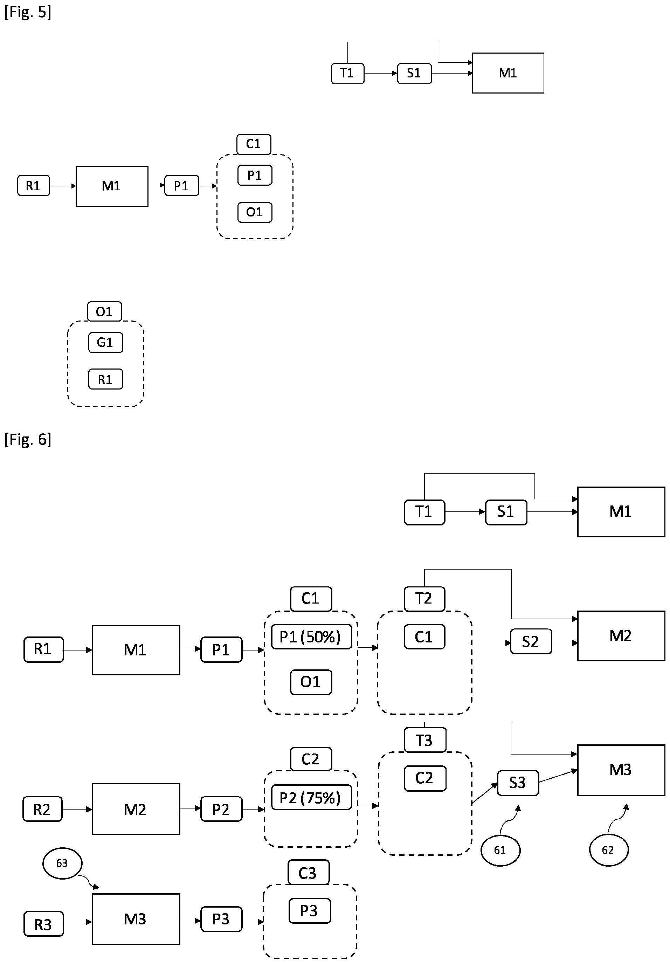

In an embodiment illustrated at figure 5 and combinable with the above described embodiments, the candidate list C1 further identifies or comprises further identifies first candidate end points O1 outside the first predicted list P1 and/or outside the another first predicted list P1'.

These candidate end points O1 can be selected outside the first predicted list P1 as a function of at least a position of the first candidate end point in the fixed communications network, a bandwidth allocation of the first candidate end point, and a traffic consumption history of the first candidate end point and/or randomly selected outside the first predicted list.

For example, the candidates end points O1 selected outside the first predicted list P1 can be selected based on educated-guess algorithm or randomly selected in the fixed communication network.

After the second short time trial period, some new supervised learning models M2 can be trained, or the existing ones (M1 or M1') can be retrained to improve the prediction accuracy. As the time passes, training data will increase, and it is expected that the supervised learning models become better and better.

In other words, it is also possible to train a second prediction model based on the result of the first prediction model M1 (or even the result of both first prediction model M1 and another first prediction model M1') i.e., based on the candidate list C1.

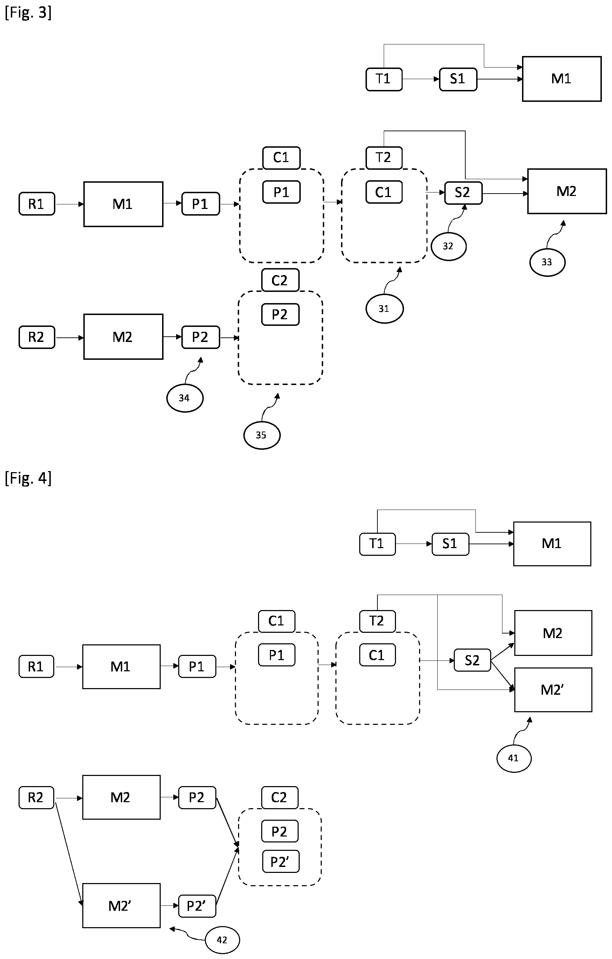

To that end, at step 31 of figure 3, a second training dataset T2 including the first candidate list C1 is provided. This second training dataset T2 comprises for each second candidate end point, a bandwidth allocation of the second candidate end point, a traffic consumption history of the second candidate end point

At figure 3, only the embodiment where the candidate list C1 comprises part or all of the predicted list P1 is depicted. However, the candidate list C1 can also be determined with the predicted list P1'.

Thus, after a second short time trial, at step 32, a second success list S2 identifying successful second candidate end points to be allocated a bandwidth increment for a long time period is provided.

The successful first candidate end points are a subset of the second candidate end points.

Then, at step 33, a second prediction model M2 is trained for predicting the second success list S2 from the second training dataset T2.

The second prediction model M2 can be the first prediction model re-trained with the second training dataset T2 and the second success list S2. In other words, performing supervised training of the second success prediction model M2 can comprise performing supervised re-training of the first success prediction model M1 for predicting the second success list S2 from the second training dataset T2. In this case, the second success prediction model M2 is the re-trained first success prediction model M1.

It is possible to combine the second training dataset T2 and the second success list S2 with any other information that the operator can collect about the end points, either from the network telemetry (traffic consumption over time, number and types of ethernet and wifi devices connected to the home gateway) or from any other sources, within the limits of the applicable data privacy regulation (address, professional activity, family composition, social media activity, ...). For example, at least one the following inputs can be user to perform the supervised training of the second success prediction model M2:
- a position of the training candidate terminal in the fixed communications network,
- a bandwidth allocation of the training candidate terminal,
- a traffic consumption history of the training candidate terminal,
- a value of the bandwidth increment for the short time period;
- a topology constraint of the fixed communications network, and/or
- traffic consumption history of the fixed communications network.

This new second prediction model M2 can be used to determine a second predicted list P2 when implemented on a second reservoir dataset R2 comprising for each second potential candidate end point, a bandwidth allocation of the second potential candidate end point, a traffic consumption history of second potential candidate end point.

At step 34, the second success prediction model M2 is implemented on the second reservoir dataset R2 identifying second potential candidate end points belonging to the fixed communications network.

Thus, the second predicted list P2 identifies candidates end points as a subset of the second potential candidate end points.

At step 35, a second candidate list C2 identifying second candidate end points to be allocated a bandwidth increment, wherein the second candidate end points belong to the fixed communications network, is selected.

The second candidate list C2 includes part or all of the second predicted list P2.

This second candidate list C2 can be used by the network operator to identify the end points of the network where a higher bandwidth is or would be necessary.

As this second candidate list C2 comprises part or all of the second predicted list P2, it is likely to be more accurate than the first candidate list C1 as the second prediction model M2 is a second generation model. Indeed, it is trained using the prediction of the first generation model M1 and/or M1'.

According to an analogous way, any number of prediction models of second generation can be trained. In other words, any number of prediction models can be trained for predicting the second success list S2 from the second training dataset T2.

For example, at step 41 of figure 4, another second prediction model M2' is trained for predicting the second success list S2 from the second training dataset T2. This another second prediction model M2' is different from the second prediction model M2.

Then at a step 42, the another second success prediction model M2' is implemented on the second reservoir dataset R2 identifying second potential candidate end points belonging to the fixed communications network to determine a another second predicted list P2'.

Thus, the another second predicted list P2' identifies candidates end points as a subset of the second potential candidate end points such as the second predicted list P2.

Then, it is possible to select the second candidate list C2 as including part of the second predicted list P2 and part of the another second predicted list P2'.

It is possible to evaluate the accuracy of the different methods of determination of the end points to be part of a candidate list C. As explained above, the different methods of determination of the end points can be :
- Implementing a prediction model to determine the end points,
- Implementing an educated-guess algorithm to determine the end points,
- Randomly determining the end points

Thus, to evaluate the method of determination consisting in implement the first prediction model, it is possible to determine a success rate of the first predicted list P1 as a function of the second success list S2 and determining a success rate of the first candidate end points O1 outside the first predicted list P1 as a function of the second success list S2.

Basically, one way to do it can be to compare the number of end points in the success list S1 coming from the first predicted list P1 and the number of end points in the success list S1 coming the first candidate end points O1 outside the first predicted list.

Then, it is possible to increase or decrease a proportion of the end points determined with one method of determination or another according to their corresponding success rate.

An example is depicted at FIG. 6, in this example, a first prediction model M1 and a second prediction model M2 have already been trained as explained above.

The first candidate list C1 used to build the second training dataset T2 comprises part of end points of the first predicted list P1 and end points O1 outside the first predicted list P1.

As an example, the proportion of the end points of the predicted list P1 in the candidate list C1 is 50%.

Then, to train a third prediction model M3, the proportion of the end points of the predicted list P2 in the candidate list C2 used to build the third training dataset T3 has increased to 75% because a success rate of the first prediction list P1 is better than a success rate of the first candidate end points O1 outside the first predicted list P1.

If the success rate of the first candidate end points O1 outside the first predicted list P1 was better than the success rate of the first prediction list P1, the proportion of the first candidate end points O1 outside the first predicted list P1 in the second candidate list would have increased (not illustrated).

This iterative allocation between different models and algorithms is performed in order to maximize a certain reward, here the accuracy of the prediction. Different strategies have been proposed to solve this problem and are usually very simple to implement. Two of those strategies are mentioned below but many refinements are available in the literature and applicable.

In the epsilon-greedy strategy, the best method of determination of the end points is selected with an allocation of 1-Epsilon. The rest is uniformly distributed among the random sampling methods and the other educated guess algorithms and models to be evaluated. A typical value for epsilon is 0.1.

In the probability matching strategy, each method of determination receives an allocation which is proportional to its probability of being the best method of determination of end points. This probability can be calculated using the Bayes theorem, knowing the results of each model during the previous short time trial periods.

Whatever the chosen strategy, the fundamental concept is to find the best trade-off between exploitation and exploration. On one hand, one will want to keep exploiting the best method of determination to the maximum. However, the risk to see the performance of this model degrading over time is significant. Therefore, it is preferable to continuously "explore" the entire reservoir of end points, to detect new trends as soon as they appear in the network. That's why a minimum allocation to (at least) the random sampling method is maintained preferably.

Then, based on the third training dataset T3 and a third success list S3 provided after a third short time trial (step 61), it is possible to train the third prediction model M3 for predicting the third success list S3 from the third training dataset T3 (step 62).

It is possible to combine the third training dataset T3 and the third success list 53 with any other information that the operator can collect about the end points, either from the network telemetry (traffic consumption over time, number and types of ethernet and wifi devices connected to the home gateway) or from any other sources, within the limits of the applicable data privacy regulation (address, professional activity, family composition, social media activity, ...). For example, at least one the following inputs can be user to perform the supervised training of the third success prediction model M3:
- a position of the training candidate terminal in the fixed communications network,
- a bandwidth allocation of the training candidate terminal,
- a traffic consumption history of the training candidate terminal,
- a value of the bandwidth increment for the short time period;
- a topology constraint of the fixed communications network, and/or
- traffic consumption history of the fixed communications network.

Similarly with the prediction model M2, the third prediction model M3 can be the second prediction model M2 re-trained with the third training dataset T3 and the third success list S3. In other words, performing supervised training of a third success prediction model can comprises:
- performing supervised re-re-training of the first success prediction model M1 for predicting the third success list S3 from the third training dataset T3. In this case, the third success prediction model M3 is the re-re-trained first success prediction model M1, or
- performing supervised re-training of the second success prediction model M2 for predicting the third success list S3 from the third training dataset T3. In this case, the third success prediction model M3 is the re-trained second success prediction model M2.

Then, at a step 63, the third prediction model M3 can be implemented on a third reservoir R3 (comprising for each third potential candidate end point at least, a bandwidth allocation of the third potential candidate end point, a traffic consumption history of third potential candidate end point) to determine a third predicted list P3 identifying third potential candidate end points belonging to the fixed communications network, wherein the third predicted list identifies candidates end points as a subset of the third potential candidate end points.

Similarly with the reservoirs R1 and R2, the third reservoir dataset R3 comprises for each third potential candidate end point at least, a bandwidth allocation of the third potential candidate end point, a traffic consumption history of third potential candidate end point.

Then, at step 64, a third candidate list C3 identifying third candidate end points to be allocated a bandwidth increment is selected or defined, wherein the third candidate end points belong to the fixed communications network.

The third candidate list includes C3 part or all of the third predicted list P3.

It is possible to evaluate the accuracy of two different prediction models M and then adjust the proportion of the corresponding predicted lists P in a new candidate list C.

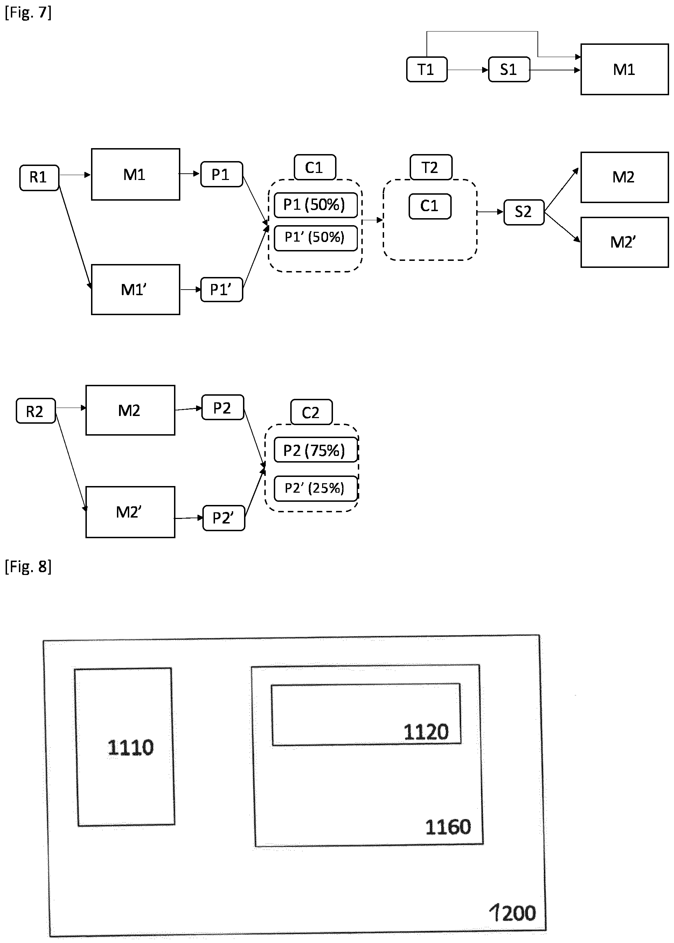

For example, at FIG. 7, two predictions models of first generation - the first prediction model M1 and the another first prediction model M1' - have been trained as explained above.

A first candidate list C1 comprising part of both predicted list P1 and P1' has been selected and then used to provide a second training dataset T2.

As an example, the predicted list P1 and the another predicted list P1' both have a proportion of 50% in the first candidate list C1.

This second training dataset T2 has been used with a second success list S2 to train two prediction model of second generation : the second prediction model M2 and the another second prediction model M2'.

Those two prediction M2 and M2' have been implemented to obtain the second predicted list P2 and the another second predicted list P2' as explained above. Preferably, the second prediction model M2 is the re-trained first prediction model M1 and the another prediction model M2' is the re-trained another first prediction model M1'.

Then here, as, for example, a success rate of the first predicted list P1 is greater than a success rate of the another predicted list P1'. So, the second candidate list C2 is selected so that a proportion of the second predicted list P2 within the second candidate list C2 is higher than a proportion of the another second predicted list P2' within the second candidate list C2.

Here, for example, at step 71, the proportion of the second predicted list P2 within the second candidate list C2 is 75% whereas the proportion of the another second predicted list P2' within the second candidate list C2 is 25%.

### Apparatus

Figure 8 is a block diagram depicting the apparatus 1200 operating in accordance with an example embodiment described above. The apparatus 1200 may be, for example, an electronic device such as a chip, chip-set, an electronic device or an access network controller. The apparatus 1200 includes a processor 1110 and a memory 1160. In other examples, the apparatus 1200 may comprise multiple processors.

In the example of Figure 8, the processor 1110 is a control unit operatively connected to read from and write to the memory 1160. The processor 1110 may also be configured to receive control signals received via an input interface and/or the processor 1110 may be configured to output control signals via an output interface. In an example embodiment the processor 1110 may be configured to convert the received control signals into appropriate commands for controlling functionalities of the apparatus.

The memory 1160 stores computer program instructions 1120 which when loaded into the processor 1110 control the operation of the apparatus 1200 according to the different embodiments explained above. In other examples, the apparatus 1200 may comprise more than one memory 1160 or different kinds of storage devices.

Computer program instructions 1120 for enabling implementations of example embodiments of the invention or a part of such computer program instructions may be loaded onto the apparatus 1200 by the manufacturer of the apparatus 1200, by a user of the apparatus 1200, or by the apparatus 1200 itself based on a download program, or the instructions can be pushed to the apparatus 1200 by an external device. The computer program instructions may arrive at the apparatus 200 via an electromagnetic carrier signal or be copied from a physical entity such as a computer program product, a memory device or a record medium such as a Compact Disc (CD), a Compact Disc Read- Only Memory (CDROM), a Digital Versatile Disk (DVD) or a Blu-ray disk.

According to an example embodiment, the apparatus 1200 comprises means, wherein the means comprises at least one processor 1110, at least one memory 1160 including computer program code 1120, the at least one memory 1160 and the computer program code 1120 configured to, with the at least one processor 1110, cause the performance of the apparatus 1200.

Embodiments of the present invention may be implemented in software, hardware, application logic or a combination of software, hardware and application logic. The software, application logic and/or hardware may reside on the apparatus, a separate device or a plurality of devices. If desired, part of the software, application logic and/or hardware may reside on the apparatus, part of the software, application logic and/or hardware may reside on a separate device, and part of the software, application logic and/or hardware may reside on a plurality of devices. In an example embodiment, the application logic, software or an instruction set is maintained on any one of various conventional computer-readable media. In the context of this document, a 'computer- readable medium' may be any media or means that can contain, store, communicate, propagate or transport the instructions for use by or in connection with an instruction execution system, apparatus, or device, such as a computer, with an example of a computer described and depicted in Figure 6. A computer-readable medium may comprise a computer-readable storage medium that may be any media or means that can contain or store the instructions for use by or in connection with an instruction execution system, apparatus, or device, such as a computer.

If desired, the different functions discussed herein may be performed in a different order and/or concurrently with each other. Furthermore, if desired, one or more of the above-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It will be obvious to a person skilled in the art that, as the technology advances, the inventive concept can be implemented in various ways. The invention and its embodiments are not limited to the examples described above but may vary within the scope of the claims.

## Claims

1. A computer-implemented method for selecting candidates end points, the method comprising:
- providing a first training dataset (T1) identifying training candidate end points to be allocated a bandwidth increment for a short time period, wherein the training candidate end points belong to a fixed communications network,
the training dataset further comprising for each training candidate end point at least:
a bandwidth allocation of the training candidate end point,
a traffic consumption history of the training candidate end point,
- providing a first training success list (S1) identifying successful training candidate end points to be allocated a bandwidth increment for a long time period, wherein the successful training candidate end points are a subset of the first training candidate end points;
- performing supervised training of a first success prediction model (M1) for predicting the first training success list from the first training dataset
- determining a first predicted list (P1) by implementing the first success prediction model (M1) on a first reservoir dataset (R1) identifying first potential candidate end points belonging to the fixed communications network wherein the first predicted list (P1) identifies candidates end points as a subset of the first potential candidate end points, the first reservoir dataset (R1) comprising for each first potential candidate end point at least:
a bandwidth allocation of the first potential candidate end point,
a traffic consumption history of the first potential candidate end point, and
- selecting a first candidate list (C1) identifying first candidate end points to be allocated a bandwidth increment, wherein the first candidate end points belong to the fixed communications network,
wherein the first candidate list (C1) includes part or all of the first predicted list (P1).

2. A computer-implemented method according to claim 1 further comprising:
- performing supervised training of another first success prediction model (M1') for predicting the first training success list (S1) from the first training dataset (T1), the another first success prediction model (M1') being different from the first success prediction model (M1).
- determining another first predicted list (P1') by implementing the another first success prediction model (M1') on the first reservoir dataset (R1) identifying first potential candidate end points belonging to the fixed communications network,
wherein the another first predicted list (P1') identifies candidates end points as a subset of the first potential candidate end points,
wherein the first candidate list (C1) includes part or all of the first predicted list (P1) and part or all of the another first predicted list (P1').

3. A computer-implemented method according to any of the preceding claims , further comprising:
- providing a second training dataset (T2) including the first candidate list (C1) and comprising for each second candidate end point, a bandwidth allocation of the second candidate end point, a traffic consumption history of the second candidate end point, providing a second success list (S2) identifying successful first candidate end points to be allocated a bandwidth increment for a long time period, wherein the successful second candidate end points are a subset of the second candidate end points;
- performing supervised training of a second success prediction model (M2) for predicting the second success list (S2) from the second training dataset (T2),
- determining a second predicted list (P2) by implementing the second success prediction model (M2) on a second reservoir dataset (R2) identifying second potential candidate end points belonging to the fixed communications network wherein the second predicted list identifies candidates end points as a subset of the second potential candidate end points,
the second reservoir dataset (R2) comprising for each second potential candidate end point, a bandwidth allocation of the second potential candidate end point, a traffic consumption history of second potential candidate end point,
- selecting a second candidate list (C2) identifying second candidate end points to be allocated a bandwidth increment, wherein the second candidate end points belong to the fixed communications network,
wherein the second candidate list (C2) includes part or all of the second predicted list (P2).

4. A computer-implemented method according to any of the preceding claims 2 and 3, further comprising:
- performing supervised training of another second success prediction model (M2') for predicting the second training success list (S2) from the second training dataset (T2), the another second success prediction model being different from the second success prediction model.
- determining another second predicted list (P2') by implementing the another second success prediction model (M2') on the second reservoir dataset (R2) identifying second potential candidate end points belonging to the fixed communications network, wherein the second candidate list (C2) includes part or all of the second predicted list (P2) and part or all of the another second predicted list (P2').

5. A computer-implemented method according to the claim 3 or 4, wherein
performing supervised training of a second success prediction model (M2) comprises performing supervised re-training of the first success prediction model (M1) for predicting the second success list (S2) from the second training dataset (T2), wherein the second success prediction model (M2) is the re-trained first success prediction model (M1).

6. A computer-implemented method according to claim 1 to 5, wherein the first
candidate list (C1) further identifies first candidate end points (O1) outside the first predicted list (P1) and/or outside the another first predicted list (P1').

7. A computer-implemented method according to claim 6, wherein selecting a first
candidate list (C1) further comprises:
- selecting a first candidate end point (G1) outside the first predicted list as a function of at least a position of the first candidate end point in the fixed communications network, a bandwidth allocation of the first candidate end point, and a traffic consumption history of the first candidate end point; and/or
- randomly selecting a first candidate end point (R1) outside the first predicted list.

8. A computer-implemented method according to claim 6 or 7, further comprising:
determining a success rate of the first predicted list as a function of the second success list and
determining a success rate of the first candidate end points outside the first predicted list as a function of the second success list.

9. A computer-implemented method according to claim 8, further comprising:
- in response to determining that the success rate of the first predicted list (P1) is higher than the success rate of the first candidate end points (O1) outside the first predicted list, the second candidate list (C2) is selected so that a proportion of the second predicted list (P2) within the second candidate list is higher than a proportion of the first predicted list within the first candidate list (P1),
- providing a third training dataset (T3) including the second candidate list (C2) and comprising for each third candidate end point at least a position of the second candidate end point in the fixed communications network, a bandwidth allocation of the second candidate end point, a traffic consumption history of the second candidate end point, ;
- providing a third success list (S3) identifying successful third candidate end points to be allocated a bandwidth increment for a long time period, wherein the successful third candidate end points are a subset of the third candidate end points;
- performing supervised training of a third success prediction model (M3) for predicting the third success list (S3) from the third training dataset (T3),
- determining a third predicted list (P3) by implementing the third success prediction model (M3) on a third reservoir dataset (R3) identifying third potential candidate end points belonging to the fixed communications network, wherein the third predicted list identifies candidates end points as a subset of the third potential candidate end points,
the third reservoir dataset (R3) comprising for each third potential candidate end point at least, a bandwidth allocation of the third potential candidate end point, a traffic consumption history of third potential candidate end point,.
- selecting a third candidate list (C3) identifying third candidate end points to be allocated a bandwidth increment, wherein the third candidate end points belong to the fixed communications network,
wherein the third candidate list includes (C3) part or all of the third predicted list (P3).

10. A computer-implemented method according to claim 4 to 8 and claim 9 comprising
- determining a success rate of the first predicted list (P1) as a function of the first success list and determining a success rate of the another first candidate end points of the another first predicted list (P1') as a function of the first success list.
- in response to determining that the success rate of the first predicted list (P1) is higher than the success rate of the another first candidate end points of the another first predicted list (P1'),
the second candidate list (C2) is selected so that a proportion of the second predicted list (P2) within the second candidate list is higher than a proportion of the another second predicted list (P2') within the second candidate list (C2).

11. A computer-implemented method according to the claim 7, wherein performing supervised training of a third success prediction model comprises:
- performing supervised re-re-training of the first success prediction model (M1) for predicting the third success list (S3) from the third training dataset (T3), wherein the third success prediction model (M3) is the re-re-trained first success prediction model (M1), or
- performing supervised re-training of the second success prediction model (M2) for predicting the third success list (S3) from the third training dataset (T3), wherein the third success prediction model (M3) is the re-trained second success prediction model (M2).

12. A computer-implemented method according to any of the preceding claims,
wherein the first success prediction model, the second success prediction and/or the third success prediction model is one of the following:
- a logistic regression based model,
- a naive bayes based model,
- a decision tree based model,
- a random forest based model,
- a support vector machine model,
A K-nearest neighbor model,
- a neural network based model.

13. A computer-implemented method according to any of the preceding claims, implemented by a network access manager of the fixed communication network.

14. A computer-implemented method according to any of the preceding claims
wherein the fixed communication network is an optical distribution network (ODN), for example a Gigabit-capable Passive Optical Network (GPON).

15. Apparatus for selecting candidates end points comprising means for:
- providing a first training dataset (T1) identifying training candidate end points to be allocated a bandwidth increment for a short time period, wherein the training candidate end points belong to a fixed communications network,
the training dataset further comprising for each training candidate end point at least:
a bandwidth allocation of the training candidate end point,
a traffic consumption history of the training candidate end point,
- providing a first training success list (S1) identifying successful training candidate end points to be allocated a bandwidth increment for a long time period, wherein the successful training candidate end points are a subset of the first training candidate end points;
- performing supervised training of a first success prediction model (M1) for predicting the first training success list from the first training dataset
- determining a first predicted list (P1) by implementing the first success prediction model (M1) on a first reservoir dataset (R1) identifying first potential candidate end points belonging to the fixed communications network wherein the first predicted list (P1) identifies candidates end points as a subset of the first potential candidate end points,
the first reservoir dataset (R1) comprising for each first potential candidate end point at least:
a bandwidth allocation of the first potential candidate end point,
a traffic consumption history of the first potential candidate end point, and
- selecting a first candidate list (C1) identifying first candidate end points to be allocated a bandwidth increment, wherein the first candidate end points belong to the fixed communications network,
wherein the first candidate list (C1) includes part or all of the first predicted list (P1).
